# EUROPEAN PATENT APPLICATION

(11) **EP 4 693 386 A1**
(43) Date of publication of application: **11.02.2026**
(21) Application number: 25190869.5
(22) Date of filing: 22.07.2025
(51) Int. Cl.: H01L 21/768, H01L 23/48, H01L 23/522, H01L 23/528, H01L 23/535, H01L 21/268, H10D 84/80, H10D 84/85

(54) **SEMICONDUCTOR CIRCUIT WITH BACK-SIDE PARTIAL-SUBSTRATE POWER RAILS**

(30) Priority: 08.08.2024 IN 202441060056
(71) Applicant: NXP USA, Inc., Austin, TX 78735 (US)
(72) Inventor: Reber, Douglas Michael, 5656AG Eindhoven (NL); Bhooshan, Rishi, 5656AG Eindhoven (NL); Demircan, Ertugrul, 5656AG Eindhoven (NL); Shroff, Mehul D, 5656AG Eindhoven (NL)
(74) Representative: Colaiuda, Antonella

(57) **Abstract**

A back-side ground and power-distribution network is formed on a semiconductor wafer substrate by selectively etching first and second back-side partial-substrate rail (PSR) trench openings through a back-side surface of the wafer substrate, selectively forming a plurality of defined n-type conductive regions and defined p-type conductive regions in the wafer substrate at the bottoms of the first and second back-side PSR trench openings in position for electrical contact with n-well and p-well regions, and then forming first and second back-side PSR conductors in the first and second back-side PSR trench openings to be directly electrically connected over the plurality of defined n-type conductive regions and defined p-type conductive regions to the n-well and p-well regions in the wafer substrate.

## Description

### BACKGROUND OF THE INVENTION

### Field of the Invention

The present disclosure is directed in general to the field of semiconductor devices. In one aspect, the present disclosure relates to power and ground connector structures formed on and through semiconductor devices.

### Description of the Related Art

Conventionally, integrated-circuits use conductive interconnect layers or levels formed on the wafer front-side to connect signal and power delivery routing to integrated-circuits, but as semiconductor fabrication processes advance toward future nodes with shrinking interconnect stacks, there are increasingly resistance, capacitance, and power consumption issues which arise with using the conductive interconnects on the wafer front-side for both power and signal routing. When the power demand becomes too great, existing solutions have sought to enhance the conductivity of the conductive power supply interconnects, such as by adding more metal levels, making the Alucap (AP) final metallization thicker, or switching to copper pillar arrangements which allow power to be more directly delivered throughout the die, as opposed to wire bonding which is typically only from the chip periphery. In recent years, on-chip power delivery has been improved by decoupling the signal and power routing to the integrated-circuits by moving the power wiring to the wafer back-side while signal routing is kept in the traditional wafer front-side. However, there are challenges with introducing power and signal routing on the wafer back-side, including localized stress effects in the substrate that result from creating back-side via conductors, potential interference with back-side circuit elements (e.g., decoupling capacitors), processing challenges with creating through-silicon via (TSV) interconnects structures in a semiconductor substrate material, process compatibility with wafer front-end-of-line (FEOL) and back-end-of-line (BEOL) wafer fabrication or alternatively for silicon-based package solutions. Further limitations and disadvantages of conventional processes and technologies will become apparent to one of skill in the art after reviewing the remainder of the present application with reference to the drawings and detailed description which follow.

### BRIEF DESCRIPTION OF THE DRAWINGS

The present invention may be understood, and its numerous objects, features and advantages obtained, when the following detailed description of a preferred embodiment is considered in conjunction with the following drawings.
Figures 1-20 illustrate cross-sectional and plan views at different stages of manufacture of a semiconductor structure having separate back-side ground and power delivery conductors formed with partial-substrate rail conductors in accordance with selected embodiments of the present disclosure.
Figure 21 illustrates a simplified process flow fabricating separate back-side ground and power delivery conductors formed with conductive partial-substrate rail structures in accordance with selected embodiments of the present disclosure.

### DETAILED DESCRIPTION

An integrated-circuit fabrication process and resulting integrated-circuit are described for fabricating separate ground- and power-distribution conductors with back-side conductive partial-substrate rail (PSR) structures to maximize the power and ground distribution and direct connection buried well regions. Depending on the type of material used to form the wafer semiconductor substrate, the term "PSR" may refer to a "partial-substrate rail" (when the wafer semiconductor substrate is formed with silicon), but may also refer to a "partial-semiconductor rail" or a "partial-substrate rail" (when the wafer semiconductor substrate is formed with a semiconductor material that includes, but is not limited to silicon). In selected embodiments, the conductive back-side ground- and power-distribution PSR structures are integrated with back-side decoupling capacitors plates to maximize the power and ground distribution in a die and decoupling capacitor area while providing a highly effective Electromagnetic Interference (EMI) shield. In selected embodiments, the conductive back-side ground- and power-distribution PSR structures are fabricated by selectively forming patterned conductive implant regions at the bottom of back-side PSR trench openings for contact with underlying well regions, annealing the implant regions at the bottom of back-side PSR trench openings with a femtosecond laser-anneal process, and then filling the PSR trench openings with one or more conductive layers to form the conductive back-side ground and power-distribution PSR structures after performing the FEOL and BEOL wafer-processing steps. Among other advantages of the back-side conductive PSR structures, the resulting integrated-circuit devices can be connected in three-dimensional multi-die packaging arrangements since the larger size of the conductive power rails allows for ready alignment and connection between chips.

In this disclosure, an improved integrated-circuit (IC) design, structure, and method of manufacture are described for forming conductive back-side ground and power-distribution PSR structures that may be integrated with a back-side decoupling capacitor to address various problems in the art where various limitations and disadvantages of conventional solutions and technologies will become apparent to one of skill in the art after reviewing the remainder of the present application with reference to the drawings and detailed description provided herein. Various illustrative embodiments of the present invention will now be described in detail with reference to the accompanying figures. While various details are set forth in the following description, it will be appreciated that the present invention may be practiced without these specific details, and that numerous implementation-specific decisions may be made to the invention described herein to achieve the device designer's specific goals, such as compliance with process technology or design-related constraints, which will vary from one implementation to another. While such a development effort might be complex and time-consuming, it would nevertheless be a routine undertaking for those of ordinary skill in the art having the benefit of this disclosure. For example, selected aspects are depicted with reference to simplified cross sectional drawings of a semiconductor device without including every device feature or geometry in order to avoid limiting or obscuring the present invention. Such descriptions and representations are used by those skilled in the art to describe and convey the substance of their work to others skilled in the art. It is also noted that, throughout this detailed description, certain elements in the figures are illustrated for simplicity and clarity and have not necessarily been drawn to scale. In addition, the dimensions of some of the elements in the figures may be exaggerated relative to other elements to help improve the understanding of the embodiments of the present disclosure. Further, reference numerals have been repeated among the drawings to represent corresponding or analogous elements. In addition, the depicted device layers that are shown as being deposited and/or etched are represented with simplified line drawings, though it will be appreciated that, in reality, the actual contours or dimensions of device layers will be non-linear, such as when the described etch processes are applied at different rates to different materials, or when the described deposition or growth processes generate layers based on the underlaying materials.

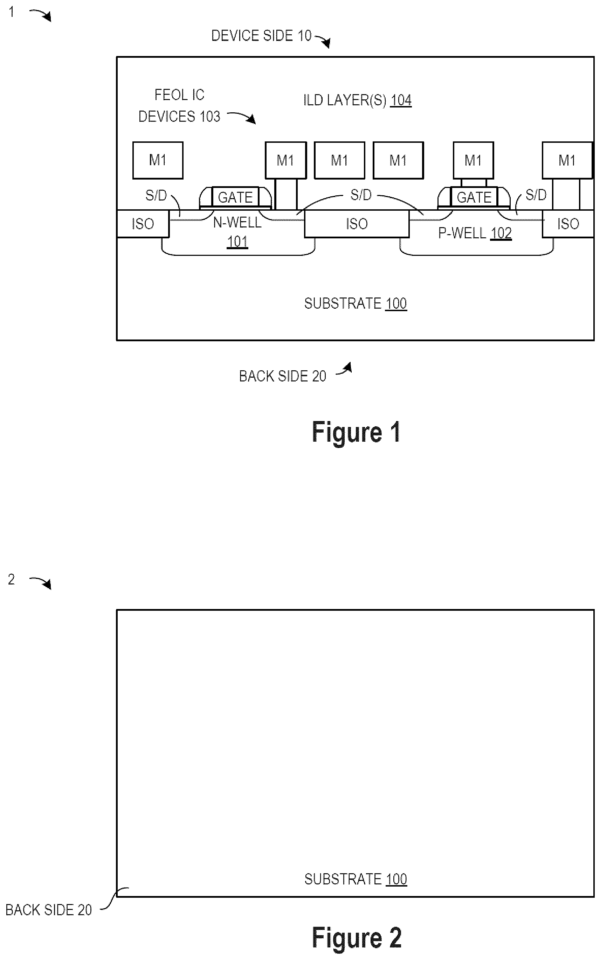

Various illustrative embodiments of the present invention will now be described in detail with reference to Figures 1-21. In addition, although specific example materials, thicknesses, and processes are described herein, those skilled in the art will recognize that other materials, thicknesses, and processes with similar properties or characteristics can be substituted without loss of function. It is noted that, throughout this detailed description, certain layers of materials will be deposited and removed to form the semiconductor structure. Where the specific procedures for processing such layers or thicknesses of such layers are not detailed below, conventional techniques known to one skilled in the art for depositing, removing, forming, or otherwise processing such layers at appropriate thicknesses shall be intended. Such details are well known and not considered necessary to teach one skilled in the art how to make or use the present invention.

Turning now to Figure 1, there is illustrated a cross-sectional view of a portion of a semiconductor structure 1 having one or more inter-layer dielectric (ILD) layers 104 and a first metal line conductor layer M1 formed over a device side (or front-side) surface 10 of a semiconductor substrate 100 in which one or more n-well regions 101 and/or p-well regions 102 are formed with integrated-circuit (IC) devices or elements 103 using front-end-of-line (FEOL) wafer-processing steps. In addition, Figure 2 shows a bottom plan view 2 of the back-side surface 20 of the substrate 100. As will be appreciated, the device side (or front-side) surface 10 is the surface on the semiconductor substrate or wafer where IC devices are formed, and the back-side surface 20 is the opposite surface on the semiconductor substrate or wafer. The disclosed semiconductor structure 100 may be implemented as a bulk silicon substrate, monocrystalline silicon (doped or undoped), or any semiconductor material including, for example, Si, SiC, SiGe, SiGeC, Ge, GaAs, InAs, InP as well as other Group III-V compound semiconductors or any combination thereof, and may be formed as the bulk handling wafer. In selected embodiments, the depicted semiconductor substrate 100 may have a specified thickness (e.g., 30 um) that is achieved by applying a wafer back-grind process. As disclosed herein, the FEOL IC devices 103 may include one or more transistors, resistors, capacitors, diodes, or other semiconductor components that are formed on or in the semiconductor substrate 100. For example, the depicted transistors include gates formed over source/drain regions in n-well regions 101 and/or p-well regions 102, where the transistors are separated from one another by isolation regions (ISO) and connected to patterned first metal line conductor layers M1 formed in the ILD layer(s) 104. As illustrated, the FEOL IC devices 103 are formed on the top or front-side surface 10 of the semiconductor structure 100, and not on the wafer back-side surface 20.

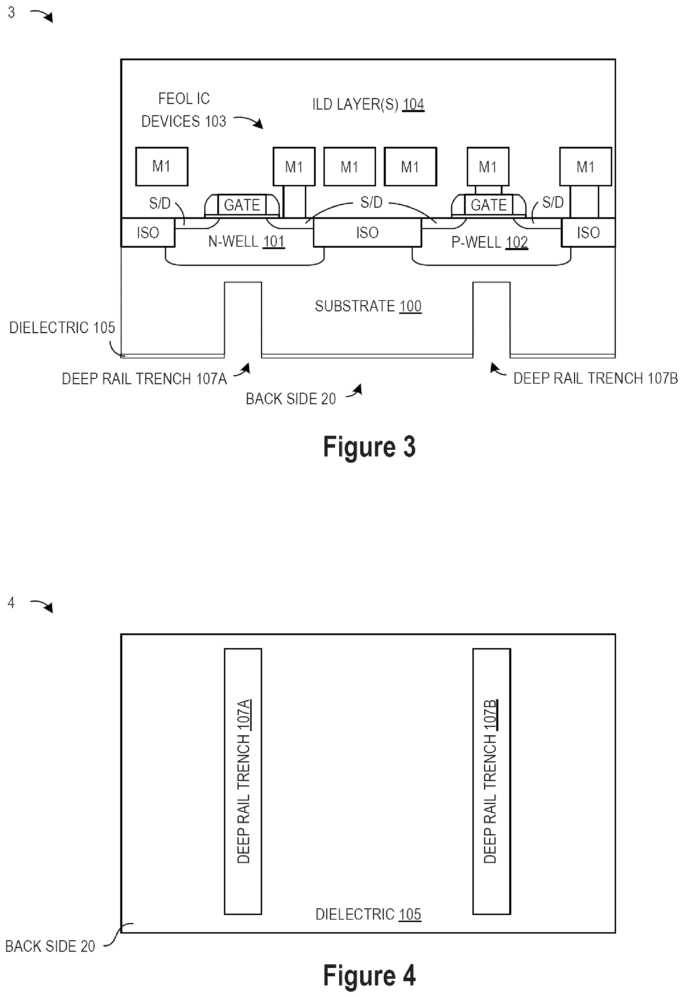

Figure 3 illustrates processing of the semiconductor structure 3 subsequent to Figure 1 after selectively forming one or more patterned dielectric layers 105 and partial-substrate rail (PSR) trench openings 107A/B in accordance with selected embodiments of the present disclosure. In addition, Figure 4 shows a bottom plan view 4 of the back-side surface 20 wherein the patterned dielectric layers 105 and PSR trench openings 107A/B are formed on the substrate 100. As will be understood by those skilled in the art, the patterned dielectric layer 105 is used as part of an etch mask with an anisotropic etch process to form the PSR trench openings 107A/B which extend through the back-side surface 20 to the approximate depth of the front-side n-wells 101 and/or p-wells 102. While any suitable anisotropic etch process(es) may be used, the etch processing can start by coating the back-side surface 20 with a dielectric layer (e.g., silicon oxide or silicon nitride) to a predetermined thickness, and then forming a patterned photoresist mask (not shown) with openings exposing the intended etch regions, and then performing a deep reactive-ion etch (RIE) step having suitable etch chemistry properties to remove the exposed portions of the underlying dielectric layer 105 and semiconductor substrate 100 to a predetermined depth. For example, a controlled etch process, such as a timed anisotropic dry etch, may be used to remove portions of the exposed regions of the underlying layers 100, 105 to a predetermined depth, thereby forming trench openings of high-aspect ratio 107A/B which substantially reach the n-well region 101 and p-well region 102 formed in the semiconductor substrate 100. While the sidewalls of the etched PSR trench openings 107A/B are substantially vertical, it will be appreciated that minor deviations in the sidewall profile may occur due to etch processing variations. As illustrated with the plan view 4 in Figure 4, the etched PSR trench openings 107A/B are formed as long, narrow trenches which extend across the length or breadth of the substrate 100, allowing for an array of trench openings that allows the finally-formed conductive back-side ground and power-distribution PSR structures to have a uniform stress distribution and reduced resistive loss as compared to back-side via conductors. In addition, by limiting the depth of the PSR trench openings so that they do not traverse entirely through the substrate 100 and protrude to the active substrate surface on the front-side 10, the location of the finally-formed conductive back-side ground and power-distribution PSR structures are not constrained by front-side design limitations, such as keep-out-zones and stress concerns encountered with through-silicon vias (TSVs).

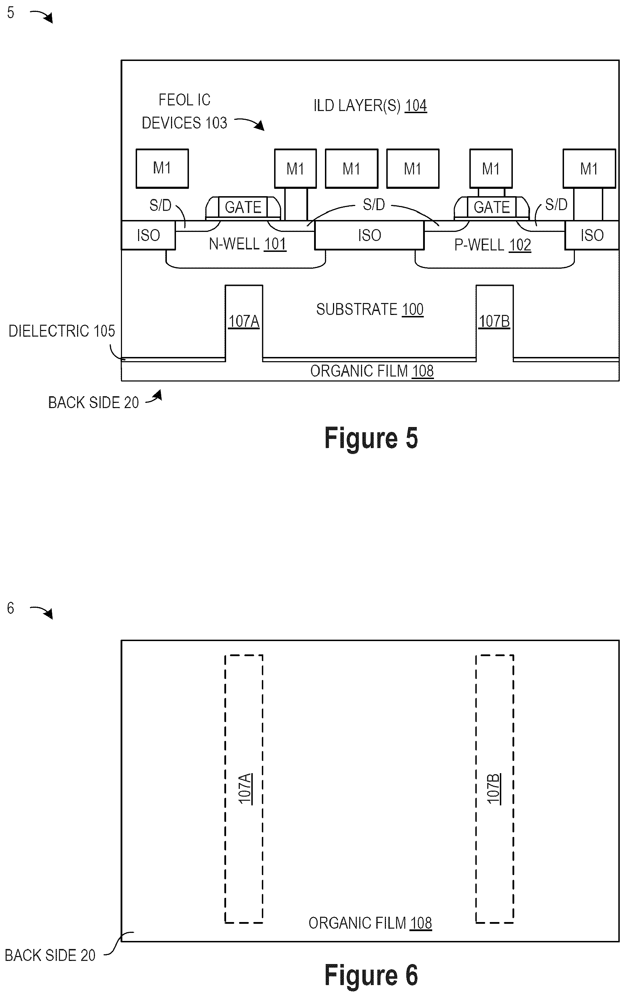

Figure 5 illustrates processing of the semiconductor structure 5 subsequent to Figure 3 after forming a trench-filling-planarizing (TFP) film layer 108 to fill the PSR trench openings 107A/B and back-side surface 20 in accordance with selected embodiments of the present disclosure. In addition, Figure 6 shows a bottom plan view 6 of the back-side surface 20 wherein the TFP layer 108 fills and covers the underlying substrate 100 and PSR trench openings 107A/B (shown in dashed lines). As will be understood by those skilled in the art, the TFP layer 108 may be formed with any suitable trench-filling material (e.g., polyimide or an epoxy-based negative photoresist, such as SU-8) that is deposited to a predetermined thickness to cover the underlying substrate 100 and PSR trench openings 107A/B. Example deposition techniques for forming the TFP layer 108 include, but are not limited to, using spin-on deposition, chemical vapor deposition (CVD), plasma-enhanced chemical vapor deposition (PECVD), squeegee, doctor-blade, or any combination(s) of the above. If desired, a chemical mechanical polish (CMP) step or other suitable planarization step may be used to form the TFP layer 108. In other embodiments, the TFP layer 108 may be formed with one or more photoimageable polyimide layers, SiOx, SiCN, SixNy or combinations and variations thereof.

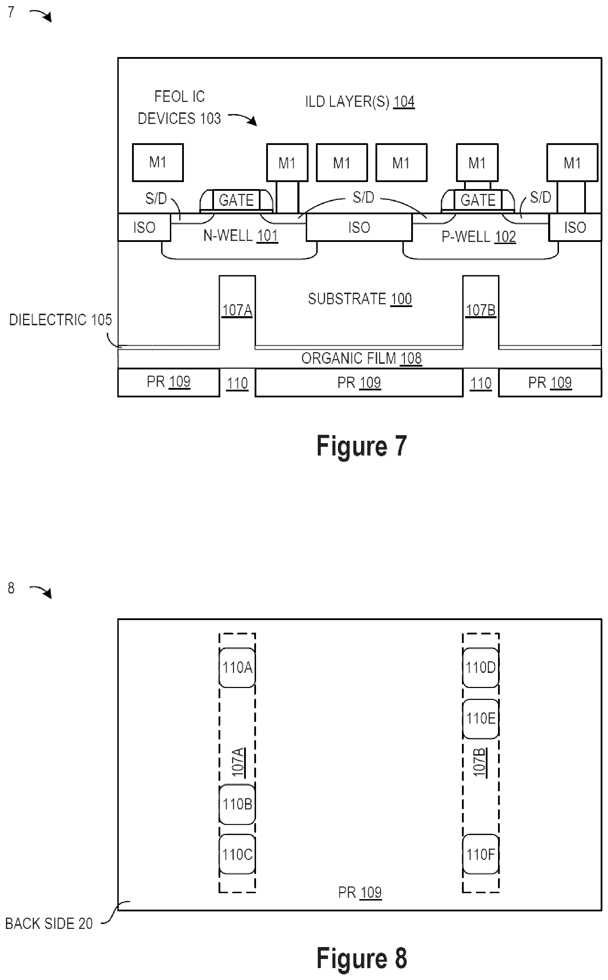

Figure 7 illustrates processing of the semiconductor structure 7 subsequent to Figure 5 after forming a patterned photoresist mask 109 to define openings 110 over the TFP layer 108 where conductive N+ and P+ implant regions will be formed in the substrate 100 at specified locations in the PSR trench openings 107A/B in accordance with selected embodiments of the present disclosure. In addition, Figure 8 shows a bottom plan view 8 of the back-side surface 20 wherein the patterned photoresist mask 109 is formed with defined openings 110A-F where the TFP layer 108 will be removed to expose the locations where the conductive N+ and P+ implant regions will be formed in the substrate 100. While any suitable photoresist patterning process may be used, the patterned photoresist mask 109 may be formed on the TFP layer 108 by depositing, patterning, etching or developing a photoresist layer formed with any material that is suitable for photolithography. For example, the patterned photoresist mask 109 may be formed by coating the TFP layer 108 with a light-sensitive organic material, applying a light source with a patterned mask over the surface of the wafer substrate which blocks light so that only unmasked regions of the material will be exposed to light, and applying a solvent to develop the material so that photo-sensitive material degraded by light and the developer will dissolve away the regions that were exposed to light, leaving behind a coating 109 where the mask was placed and mask openings 110A-F where the coating is removed. As depicted, the patterned photoresist mask 109 includes defined openings 110A-F which expose the underlying TFP layer 108 at intended etch locations where conductive N+ and P+ implant regions will be formed in the substrate 100 at specified locations in the PSR trench openings 107A/B.

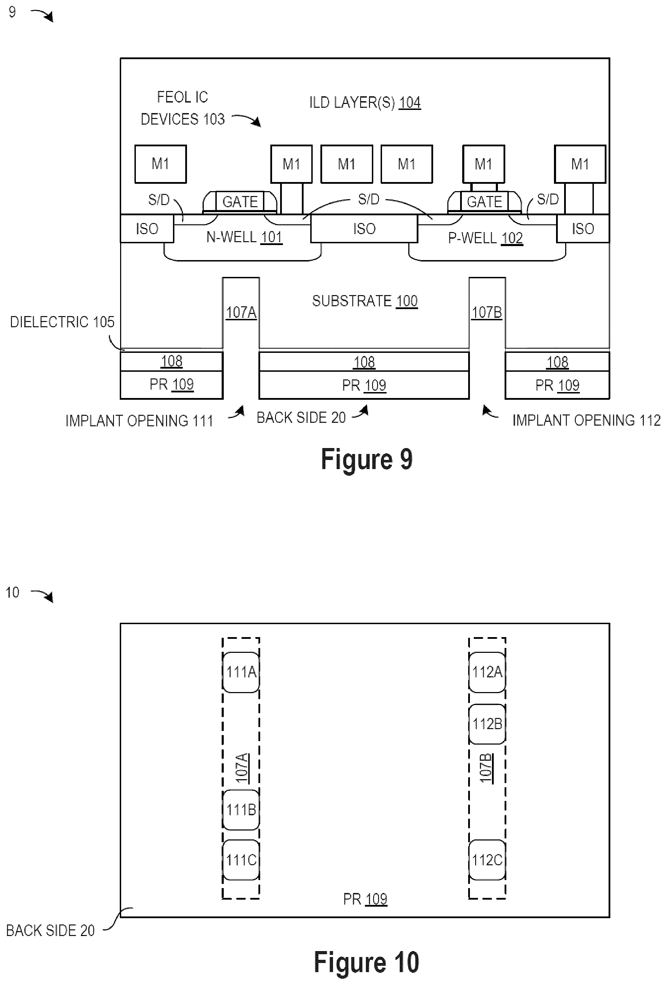

Figure 9 illustrates processing of the semiconductor structure 9 subsequent to Figure 7 after selectively etching implant openings 111, 112 through the TFP layer 108 exposed by the openings 110A-F in the patterned photoresist mask 109 in accordance with selected embodiments of the present disclosure. In addition, Figure 10 shows a bottom plan view 10 of the back-side surface 20 wherein the patterned photoresist mask 109 and etched implant openings 111A-C, 112A-C are formed to expose the locations where the conductive N+ and P+ implant regions will be formed in the substrate 100. As will be understood by those skilled in the art, the selective etch process may use any suitable anisotropic etch process(es) to form the implant openings 111, 112 which extend through TFP layer 108 formed in the PSR trench openings 107A/B to the approximate depth of the front-side n-wells 101 and/or p-wells 102. For example, with the patterned photoresist mask 109 in place, a deep reactive-ion etch (RIE) step having suitable etch chemistry properties may be applied to remove the exposed portions of the underlying TFP layer 108 to the predetermined well depth, such as by using a controlled etch process, for example a timed anisotropic dry etch, thereby forming high-aspect ratio implant openings 111A-C, 112A-C which substantially reach the n-well region 101 and p-well region 102 formed in the semiconductor substrate 100. While the sidewalls of the etched implant openings 111A-C, 112A-C are substantially vertical, it will be appreciated that minor deviations in the sidewall profile may occur due to etch processing variations. As illustrated with the plan view 10 in Figure 10, the etched implant openings 111A-C, 112A-C are formed as small via-type openings which are positioned within the narrow PSR trench openings 107A/B for alignment with the n-well regions 101 and/or p-well regions 102. In embodiments where the TFP layer 108 is formed with one or more photoimageable polyimide layers, the etch openings 111, 112 may be formed by selectively exposing the photoimageable polyimide layer(s) 108 to a patterned light source so that only unmasked regions of the photoimageable polyimide layer(s) 108 will be exposed to light, and applying a solvent to develop the photoimageable polyimide layer(s) 108 so that photo-sensitive material degraded by light and the developer will be dissolved away to form the etched implant openings 111A-C, 112A-C.

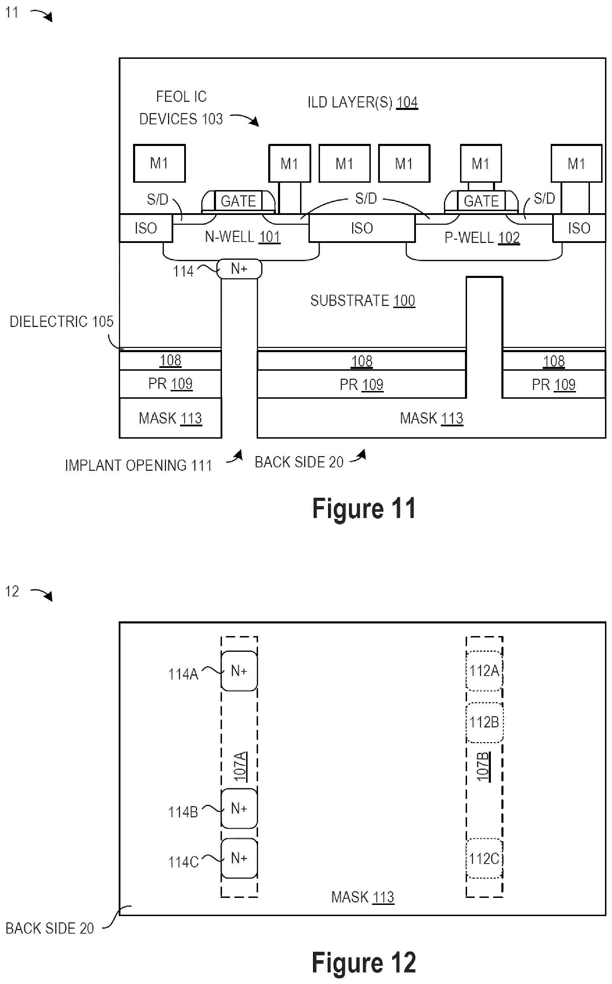

Figure 11 illustrates processing of the semiconductor structure 11 subsequent to Figure 9 after selectively implanting a first conductive implant region 114 at the bottom of selected back-side implant openings 111A-C in accordance with selected embodiments of the present disclosure. In addition, Figure 12 shows a bottom plan view 12 of the back-side surface 20 wherein the first patterned mask 113 is used to selectively implant the first conductive implant regions 114A-C at the bottom of selected back-side implant openings 111A-C. As disclosed herein, any suitable selective implantation process may be used to form the first conductive implant region 114. For example, the first conductive implant region 114 may be formed as an N+ implant by selectively implanting, through the first patterned mask 113 on the back-side surface 20, a suitable n-type dopant (e.g., Phosphorus, antimony, and Arsenic) with a suitable ion implantation energy and dopant concentration. In an example embodiment, the first patterned implant mask 113 may be formed on the back-side surface 20 of the substrate 100 by depositing or coating the semiconductor structure back-side with a photoresist layer that is subsequently developed and exposed to transfer a pattern from a mask to the semiconductor structure so that the patterned implant mask protects back-side surface 20 except for defined openings to expose the intended N+ implant region 114. With the first patterned implant mask 113 in place, an n-type ion implantation process is applied to form the N+ implant regions 114A-C at the bottom of the back-side implant openings 111A-C in contact with the n-well region 101 exposed by the patterned implant mask 113. As disclosed, the implantation power and dosage parameters of the n-type ion implantation process are controlled to implant n-type dopants 114 at the bottom of the back-side implant openings 111A-C which expose the n-well region 101 in the semiconductor substrate 100. For example, the n-type implantation process may be configured to implant any suitable n-type implant with an ion implantation energy of approximately 1-100 keV (e.g., 10 keV) and dopant concentration in the range of about 5x1014 to5x1015 atoms/cm2 (e.g., 1015 atoms/cm2), thereby forming the N+ implant regions 114A-C at a target implant depth at the bottom of the exposed back-side implant openings 111A-C. As will be appreciated, the n-type implantation process may use any suitable implantation technique, including but not limited to traditional ion implantation and plasma-immersion ion implantation for implanting the N+ implant regions 114A-C in the semiconductor substrate 100.

While Figures 11-12 show the N+ implant 114A-C being formed in the substrate 100 at the bottom of the exposed back-side implant openings 111A-C, it will be appreciated that some implantation will occur also along the sidewalls of the exposed substrate 100. In addition, it will be understood the N+ implant 114 will actually have approximately the same diameter as the exposed back-side implant openings 111A-C and will become larger with annealing, but the relative width of the N+ implant 114 is exaggerated for purposes of illustrating the present disclosure. Unless accompanied by a high temperature anneal process, the n-type implantation process will create structural disruptions in the monocrystalline structure of the semiconductor layer 100. In selected embodiments, co-implants can be performed. In addition or in the alternative, an n-type solid phase diffusion source may be used to form the N+ regions 114. As formed, the N+ implant 114 is an n-type well connect for making direct electrical connection with the n-well region 101 in the semiconductor substrate 100.

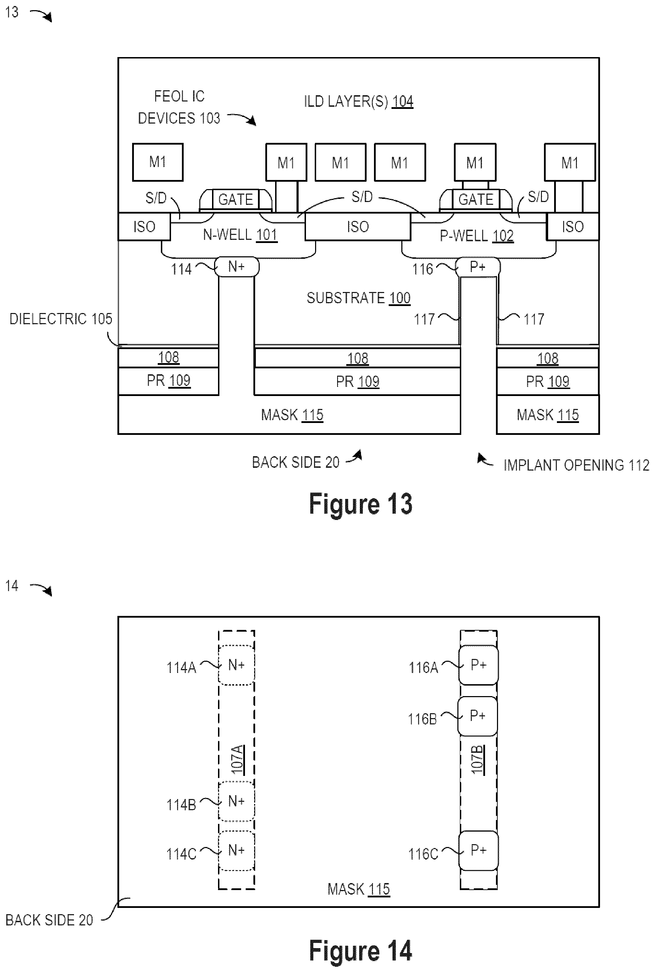

Figure 13 illustrates processing of the semiconductor structure 13 subsequent to Figure 11 after selectively implanting a second conductive implant region 116 at the bottom of selected back-side implant openings 112A-C in accordance with selected embodiments of the present disclosure. In addition, Figure 14 shows a bottom plan view 14 of the back-side surface 20 wherein the second patterned mask 115 is used to selectively implant the second conductive implant regions 116A-C at the bottom of selected back-side implant openings 112A-C. As disclosed herein, any suitable selective implantation process may be used to form the second conductive implant region 116. For example, the second conductive implant region 116 may be formed as a P+ implant by selectively implanting, through the back-side surface 9, a suitable p-type dopant (e.g., Boron, Arsenic, Phosphorus, Gallium, Aluminum) with a suitable ion implantation energy and dopant concentration. In an example embodiment, the first patterned implant mask 113 is stripped or removed before forming a second patterned implant mask 115 on the back-side surface 20 of the substrate 100 by depositing or coating the semiconductor structure back-side with a photoresist layer that is subsequently developed and exposed to transfer a pattern from a mask to the semiconductor structure so that the patterned implant mask protects back-side surface 20 except for defined openings to expose the intended P+ implant region 116. With the second patterned implant mask 115 in place, a p-type ion implantation process is applied to form the P+ implant regions 116A-C at the bottom of the back-side implant openings 112A-C in contact with the p-well region 102 exposed by the patterned implant mask 115. For example, the p-type implantation process may be configured to implant any suitable p-type implant with an ion implantation energy of approximately 1-100 keV (e.g., 10 keV) and dopant concentration in the range of about 5x1014 to5x1015 atoms/cm2 (e.g., 1015 atoms/cm2), thereby forming the P+ implant regions 116A-C at a target implant depth at the bottom of the back-side implant openings 112A-C which expose the p-well region 102 in the semiconductor substrate 100. Again, the p-type implantation process may use any suitable implantation technique, including but not limited to traditional ion implantation and plasma-immersion ion implantation for implanting the P+ implant regions 116A-C in the semiconductor substrate 100.

While Figure 13 shows the P+ implant 116 being formed in the substrate 100 at the bottom of the exposed back-side implant openings 112, it will be appreciated that some implantation will occur also along the sidewalls of the exposed substrate 100. Indeed, an angled P+ implantation process may be used as part of implanting the P+ implant regions 116A-C (or later in the fabrication process) to form implanted P+ trench sidewalls 117 to promote direct electrical connection to the substrate 100. In addition, it will be understood the P+ implant region 116 will actually have approximately the same diameter as the exposed back-side implant openings 112 and will become larger with annealing, but the relative width of the P+ implant region 116 is exaggerated for purposes of illustrating the present disclosure. Unless accompanied by a high temperature anneal process, the p-type implantation process will create structural disruptions in the monocrystalline structure of the semiconductor layer 100. In selected embodiments, co-implants can be performed. In addition or in the alternative, a p-type solid phase diffusion source may be used to form the P+ regions 116A-C. As formed, the P+ implant 116 is an p-type well connect for making direct electrical connection with the n-well region 101 in the semiconductor substrate 100. Though not shown, it will be appreciated, that an angled n-type implant may also be used to form implanted N+ trench sidewalls in the n-well implant openings 111A-C when forming the N+ implant regions 114A-C

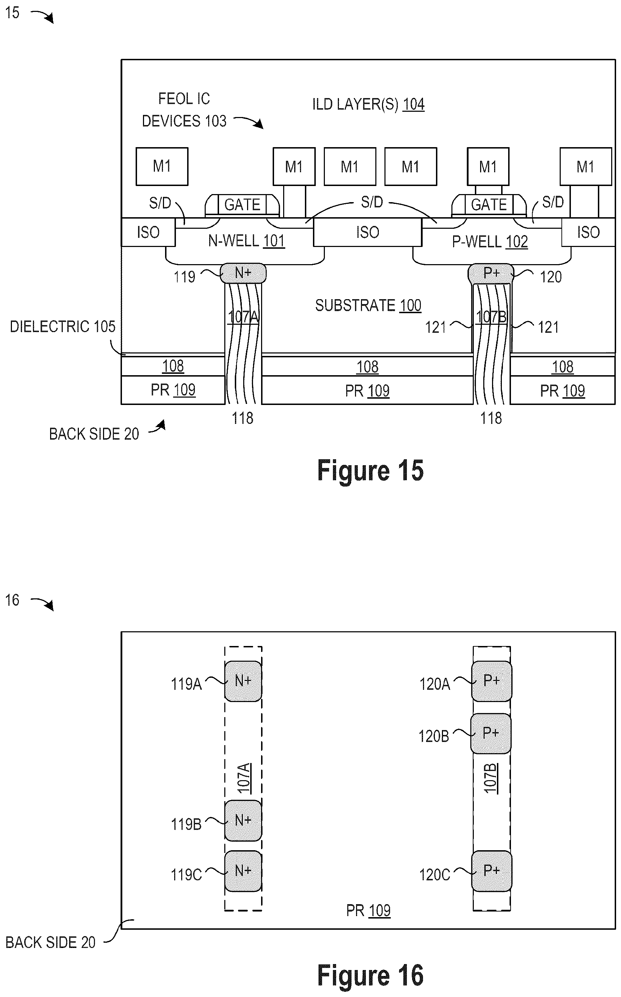

As will be appreciated, the n-type and p-type implantation processes will create structural disruptions in the monocrystalline structure of the semiconductor layer 100. However, any attempt to apply a high temperature anneal process to remove the structural disruptions at this stage of the device fabrication will drive dopants in the FEOL IC devices 103 and n-well regions 101, and p-well regions 102, thereby adversely impacting the front-side circuits. To address this issue, reference is now made to Figure 15 which illustrates processing of the semiconductor structure 15 subsequent to Figure 13 after applying a localized anneal process 118 to form conductive N+ and P+ regions 119, 120 at the bottom of selected back-side PSR trench openings 107 in accordance with selected embodiments of the present disclosure. In addition, Figure 16 shows a bottom plan view 16 of the back-side surface 20 wherein the localized anneal process 118 is used to form the conductive N+ regions 119A-C and P+ regions 120A-C at the bottom of the back-side PSR trench openings 107and to anneal the trench sidewall regions 117 resulting in annealed regions 121. At this point in the example fabrication process, the second patterned implant mask 115 is stripped or removed from the back-side surface 20 of the substrate 100, leaving in place the patterned photoresist mask 109 and TFP layer 108. With the patterned photoresist mask 109 and TFP layer 108 in place, the localized anneal process 118 may be implemented to avoid impacting the front-side circuits by scanning a femtosecond laser 118 into the back-side PSR trench openings 107 or using any other suitable localized anneal process. However implemented, the localized anneal process 118 is substantially confined to remove the structural disruptions in the N+ and P+ regions 114, 116 to form the conductive N+ and P+ regions 119A-C, 120A-C, but to otherwise not affect the diffusions in the FEOL IC devices 103, n-well regions 101, and p-well regions 102

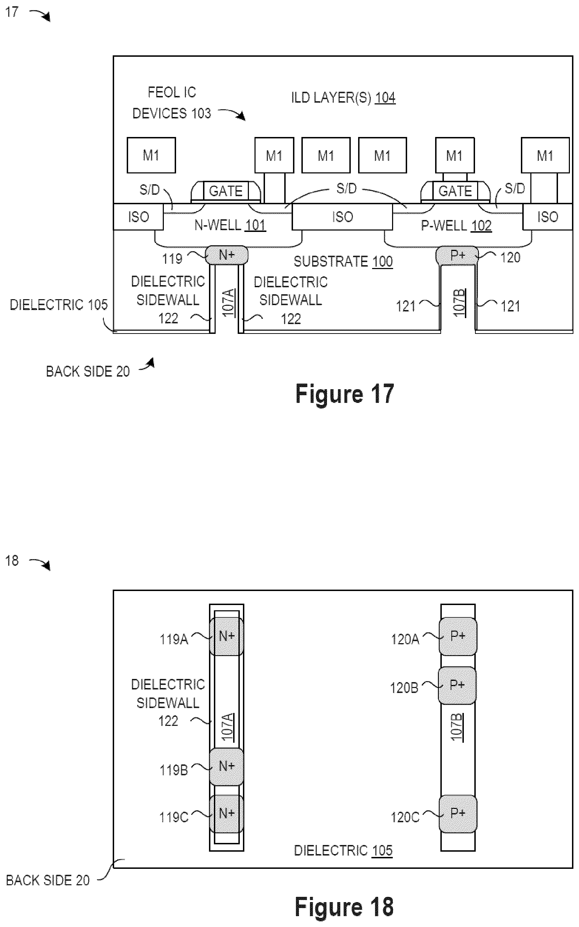

Figure 17 illustrates processing of the semiconductor structure 17 subsequent to Figure 15 after selectively forming dielectric sidewall layers 122 on the sides of selected n-well PSR trench openings 107A in accordance with selected embodiments of the present disclosure. In addition, Figure 18 shows a bottom plan view 18 of the back-side surface 20 after formation of the dielectric sidewall layers 122 on the sides of selected n-well PSR trench openings 107A. At this point in the example fabrication process, the patterned photoresist mask 109 and TFP layer 108 have been stripped or removed from the back-side surface 20 of the substrate 100, leaving in place the patterned dielectric layers 105. As disclosed herein, any suitable conformal dielectric layer formation process may be used to form the dielectric sidewall layers 122. For example, a patterned photoresist mask (not shown) may be formed on the back-side surface 20 with defined openings to expose the n-well PSR trench openings 107A but not the p-well PSR trench openings 107B. Subsequently, a suitable conformal dielectric layer 122 (e.g., Si3N4, SiO2) may be deposited to a predetermined thickness using any suitable deposition process, including but not limited to CVD, PECVD, PVD, sputtering, ALD, EE-ALD or the like. Subsequently, the deposited conformal dielectric layer 122 is patterned and etched to selectively remove it from some horizontal surfaces to the substrate 100 and to allow connection to the N+ implant regions 119A-C and the P+ implant regions 120A-C. It can be seen that if the n-well PSR 107A will not encounter any p-well regions and the PSR and the n+ implant 11 sufficiently implants the sidewalls of PSR 107A, while at the same time, the p-well PSR 107B will not encounter any n-well regions, then the dielectric-liner process 17 may be omitted. Further, in some scenarios, the patterned dielectric-liner process 17 could be performed before the implant steps of 11, 13, and 15.

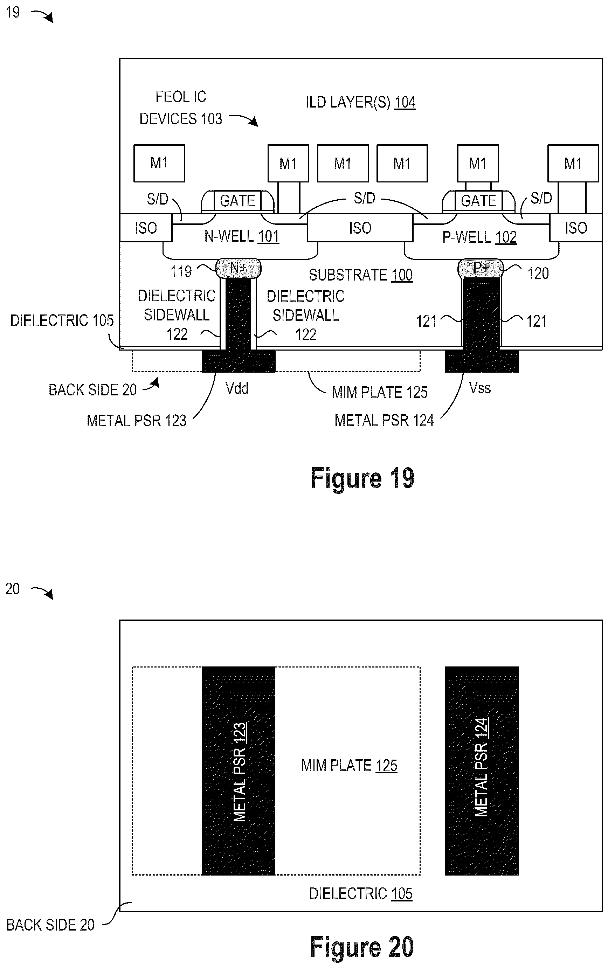

Figure 19 illustrates processing of the semiconductor structure 19 subsequent to Figure 17 after the PSR trench openings 107A/B are filled with one or more conductive layers to form metal PSR structures 123, 124 which make direct electrical contact with the n-well region 101 and p-well region 102 through, respectively, the N+ implant region 119 and P+ implant region 120 in accordance with selected embodiments of the present disclosure. In addition, Figure 20 shows a bottom plan view 20 of the back-side surface 20 after forming the metal PSR structures 123, 124 to fill the PSR trench openings 107A/B. As disclosed herein, any suitable deposition process may be used to form the metal PSR structures 123, 124. For example, the metal PSR structures 123, 124 may be formed by first depositing, over the back-side surface 20 and PSR trench openings 107A/B, a conductive barrier film or liner layer of any suitable diffusion barrier material which also allows for electro-deposition (e.g., Ti, TiN, Ta, TaN, TiN, TiC, TaC, CuWP, or the like). As part of the conductive barrier film/liner layer, one or more conductive seed layers may be formed with any suitable conductive material, such as copper, a Copper alloy, Silver, Gold, Tungsten, Aluminum, or the like. In selected embodiments, the metal PSR structures 123, 124 may be formed by blanket depositing a barrier film in the PSR trench openings 107, followed by depositing a thin seed layer (e.g., copper or copper alloy, nickel, etc.) over the barrier film, and then filling the PSR trench openings 107 with metallic material, such as by using electroplating, electroless plating, or depositing a conductive material (e.g., Cu, Co, Ni, Mn, Mg, Zn, Al, etc.). The electroplating process may be controlled to provide a bottom-up electroplating so that the metallic material is formed only on horizontal surfaces to cover the wafer back-side and the bottom of the PSR trench openings 107, and to make direct electrical contact with the N+ implant regions 119A-C and P+ implant regions 120A-C. The deposited conductive layers are then patterned and etched using any suitable selective etch process(es) to form the patterned metal PSR conductor 123 (for connection to the Vdd reference voltage) and the patterned metal PSR conductor 124 (for connection to the Vss reference voltage). In selected embodiments, the patterned metal PSR conductors 123, 124 can be selectively etched, polished, or otherwise planarized as shown.

To provide a further improvement in the fabrication of separate conductive back-side ground and power-distribution PSR structures, the process for forming the metal PSR structures 123, 124 may be modified to form a back-side decoupling MIM capacitor that is integrated with one or more of the patterned metal PSR conductors 123, 124. As indicated with the dashed lines in Figures 19-20, the back-side decoupling MIM capacitor may be formed with an integrated MIM capacitor plate 125 that is formed as an extension of the one or more conductive metal layers formed on the horizontal wafer back-side surface, and that sandwiches the patterned dielectric layer(s) 105 with a second capacitor plate formed with the semiconductor substrate 100 which serves as the ground electrode. Though not shown, the one or more patterned dielectric layers 105 may be replaced with a high-k MIM dielectric layer (not shown) prior to filling the PSR trench openings 107A/B with one or more conductive layers. In such embodiments, the patterned dielectric layer(s) 105 may be replaced with a high-k MIM dielectric layer by applying a polish and/or etch process to remove the patterned dielectric layer(s) 105, and then depositing a conformal high-k MIM dielectric layer to a predetermined thickness as a protective layer before filling the PSR trench openings 107A/B with one or more conductive layers to form the metal PSR structures 123, 124. Subsequently, the exposed PSR trench openings 107A/B are filled with one or more conductive layers, and a patterned etch process is applied to simultaneously form the patterned metal MIM plate 125 (for connection to the Vdd reference voltage) and the patterned metal PSR conductor 124 (for connection to the Vss reference voltage).

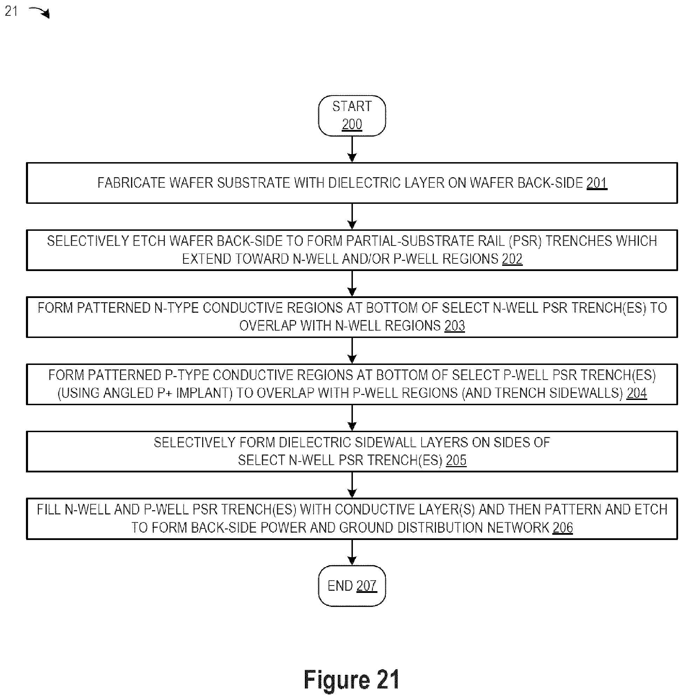

Turning now to Figure 21, there is illustrated a simplified process flow 21 for fabricating separate back-side ground and power delivery conductors with conductive partial-substrate rail (PSR) structures in accordance with selected embodiments of the present disclosure. Though selected embodiments of the back-side ground and power delivery conductor fabrication methodology are described with reference to an example fabrication process that can be integrated with a BEOL process, it will be appreciated by persons skilled in the art that the sequence of illustrated steps may be used in any suitable stage of the device fabrication process, and may be modified, reduced or augmented in keeping with the disclosure of the present invention. Thus, it will be appreciated that the methodology of the present disclosure may be thought of as performing the identified sequence of steps in the order depicted in Figure 21, though the steps may also be performed in parallel, in a different order, or as independent operations that are combined.

After starting the fabrication methodology (step 200), one or more processing steps (step 201) are used to fabricate a semiconductor wafer substrate having one or more dielectric layers formed on the back-side of the wafer substrate. As disclosed herein, the semiconductor wafer substrate may be implemented as a bulk silicon substrate, monocrystalline silicon (doped or undoped), or any semiconductor material including, for example, Si, SiC, SiGe, SiGeC, Ge, GaAs, InAs, InP as well as other Group III-V compound semiconductors or any combination thereof, and may be formed as the bulk handling wafer. In addition, the dielectric layer may be formed by depositing a layer of silicon oxide or silicon nitride to a predetermined thickness.

At step 202, partial-substrate rail (PSR) trench openings are selectively etched through the dielectric layer and into the wafer back-side to extend toward the n-well and p-well regions and/or to contact buried Vdd and/or Vss regions or power rails formed in the wafer substrate. As disclosed herein, the PSR trench openings do not extend through the entirety of the wafer substrate, but are etched only partially through the wafer substrate to a predetermined etch depth. As disclosed herein, the PSR trench openings can be formed simultaneously or sequentially by using any suitable masked etch process, such as by forming a patterned photoresist layer as an etch mask and then applying one or more anisotropic etch processes to etch partially through back-side of the wafer substrate.

At step 203, patterned n-type conductive regions are selectively formed at the bottom of the PSR trench openings to overlap with the n-well regions. In an example embodiment, the patterned n-type conductive regions may be formed at predetermined locations of the PSR trench openings by filling the PSR trench openings with a thick trench-filling planarizing (TFP) film layer, then forming a patterned hard etch mask with defined openings over the intended n-type conductive regions, then selectively etching the TFP film layer with an anisotropic RIE process to expose the intended n-type conductive regions, and then selectively implanting the n-type conductive region with an N+ implantation to make ohmic contact with the n-well region. The N+ implants may be treated with a femtosecond laser to locally anneal the n-type conductive regions, thereby removing structural implant damage from the wafer substrate. In other embodiments, the n-type conductive regions may be formed by selectively depositing and annealing a high dopant n-type source material in the PSR trench openings to make ohmic contact with the n-well regions.

At step 204, patterned p-type conductive regions are selectively formed at the bottom of the PSR trench openings to overlap with the p-well regions. In an example embodiment, the patterned p-type conductive regions may be formed at predetermined locations of the PSR trench openings by filling the PSR trench openings with a thick TFP film layer, then forming a patterned hard etch mask with defined openings over the intended p-type conductive regions, then selectively etching the TFP film layer with an anisotropic RIE process to expose the intended p-type conductive regions, and then selectively implanting the p-type conductive region with an P+ implantation to make ohmic contact with the p-well region. The P+ implants may be treated with a femtosecond laser to locally anneal the p-type conductive regions, thereby removing structural implant damage from the wafer substrate. As will be appreciated, some of the processing in steps 203, 204 may be shared, such as filling the PSR trench openings with a thick TFP film layer, forming a patterned hard etch mask with defined openings over the intended n-type and p-type conductive regions, and then selectively etching the TFP film layer with an anisotropic RIE process to expose the intended n-type and p-type conductive regions. As indicated parenthetically in step 204, the formation of the patterned p-type conductive regions may include angling the P+ implants so that the sidewalls of the PSR trench openings over the p-well region are selectively implanted, though this angled P+ implant may also be performed subsequently in the fabrication process. In other embodiments, the p-type conductive regions may be formed by selectively depositing and annealing a high dopant p-type source material in the PSR trench openings to make ohmic contact with the p-well regions. In accordance with selected embodiments of the present disclosure, steps 203 and 204 can be run interchangeably.

At step 205, dielectric sidewall layers are selectively formed on the sidewalls of selected PSR trench openings. In selected embodiments, the dielectric sidewall layers may be formed by depositing a conformal dielectric layer over the wafer back-side, followed by application of an anisotropic etch process which selectively removes the conformal dielectric layer from the wafer back-side and the bottom (but not the sidewalls) of the PSR trench openings. In other embodiments, the dielectric sidewall layers may be formed on only the sidewalls of the PSR trench openings which are formed in alignment with the n-well regions.

At step 206, the PSR trench openings are filled with one or more conductive layers, and then patterned and etched to form the back-side power and ground distribution network. In selected embodiments, the one or more conductive layers may be formed by sequentially depositing a seed layer and electroplating layer(s) to fill the PSR trench openings. The conductive layers may be planarized, patterned and etched on the wafer back-side to form a first metal PSR plate that is connected to the Vdd reference voltage, and to form a second metal PSR plate that is connected to the Vss reference voltage.

As described hereinabove, the present disclosure provides a mechanism for integrating back-side power and ground distribution network conductors with a back-side decoupling capacitor by adding conductive partial-substrate rail structures formed on the wafer back-side that electrically connect buried n-well and p-well regions in the wafer substrate to external reference voltage supplies. In addition to reducing fabrication costs and complexity for making power and ground connections, the disclosed back-side power and ground distribution network reduces front-side metallization congestion, resistance, capacitance, and power consumption issues for routing power and ground signals through the substrate back-side, while also providing improved EMI shielding from the decoupling-capacitor plates and TSVs. In addition, the back-side power and ground distribution network conductors do not traverse entirely through the semiconductor substrate and do not protrude to the top active semiconductor substrate surface, thereby reducing the need for designers to incorporate keep-out-zones and stress concerns encountered with through-silicon vias (TSV) which extend through the entirety of the semiconductor substrate. In addition, the integrating of a back-side decoupling capacitor with the back-side power and ground distribution network conductors enables high capacitance back-side MIM decoupling capacitors.

By now, it should be appreciated that there has been provided a method of forming power-distribution conductors on a back-side of a semiconductor substrate. In the disclosed methodology, a first opening is selectively formed on a back-side surface of a semiconductor substrate to extend only partway through the semiconductor substrate. In addition, a plurality of defined first conductive regions of a first conductivity type is selectively formed at a bottom portion of the first opening to be positioned for electrical contact with one or more first well regions in the semiconductor substrate. In addition, a first back-side power-distribution conductor is selectively formed in the first opening which is directly electrically connected over the plurality of defined first conductive regions to the one or more first well regions in the semiconductor substrate. In selected embodiments, the first back-side power-distribution conductor is selectively formed by sequentially depositing one or more conductive layers to fill the first opening and to cover the back-side surface of the semiconductor substrate; and selectively etching the one or more conductive layers on the back-side surface of the semiconductor substrate to form the first back-side power-distribution conductor. In selected embodiments, the disclosed method also includes selectively forming a second opening on the back-side surface of the semiconductor substrate to extend only partway through the semiconductor substrate, followed by selectively forming a plurality of defined second conductive regions of a second, opposite conductivity type at a bottom portion of the second opening to be positioned for electrical contact with one or more second well regions in the semiconductor substrate, followed by selectively forming a second back-side power-distribution conductor in the second opening which is directly electrically connected over the plurality of defined second conductive regions to the one or more second well regions in the semiconductor substrate, and followed by selectively forming one or more patterned conductive layers on the back-side surface of the semiconductor substrate to form an integrated back-side decoupling-capacitor plate which is directly electrically connected with the first or second back-side power-distribution conductor, where the integrated back-side decoupling-capacitor plate is a first metal-insulator-metal (MIM) capacitor plate and the semiconductor substrate is a second MIM capacitor plate. In selected embodiments and before selectively forming the first back-side power-distribution conductor, one or more dielectric sidewall layers are selectively formed on sidewall surfaces of at least one of the first or second openings which leave exposed the plurality of defined first conductive regions and the plurality of defined second conductive regions. In selected embodiments, the plurality of defined first conductive regions is selectively formed by selectively implanting a plurality of separate N+ implant regions into the semiconductor substrate at the bottom of the first opening, and plurality of defined second conductive regions is selectively formed by selectively implanting a plurality of separate P+ implant regions into the semiconductor substrate at the bottom of the second opening. In such embodiments, the disclosed method may further include scanning a femtosecond laser to apply a localized anneal process to anneal the plurality of separate N+ implant regions and the plurality of separate P+ implant regions. In other embodiments, the plurality of defined first conductive regions is selectively formed by selectively forming a plurality of separate N+ diffusion regions in the semiconductor substrate at the bottom of the first opening, and the plurality of defined second conductive regions is selectively formed by selectively forming a plurality of separate P+ diffusion regions in the semiconductor substrate at the bottom of the second opening. In other embodiments, the plurality of defined first conductive regions is selectively formed by filling the first opening with a first trench-filling layer; selectively etching a first plurality of back-side partial-substrate via (PSV) openings through the first trench-filling layer formed in the first opening to expose one or more n-well regions in the semiconductor substrate; and selectively implanting a plurality of separate N+ implant regions at the bottom of the first plurality of back-side PSV openings to make ohmic contact with the one or more n-well regions in the semiconductor wafer substrate. In other embodiments, the plurality of defined second conductive regions is selectively formed by filling the second opening with a first trench-filling layer; selectively etching a second plurality of back-side PSV openings through the first trench-filling layer formed in the second opening to expose one or more p-well regions in the semiconductor substrate; and selectively implanting a plurality of separate N+ implant regions at the bottom of the second plurality of back-side PSV openings to make ohmic contact with the one or more p-well regions in the semiconductor substrate.

In another form, there is provided a semiconductor wafer with back-side power and ground delivery conductors and associated method of fabrication. In the disclosed methodology, a semiconductor wafer substrate is provided that has front-side and back-side surfaces. The disclosed methodology also includes selectively etching a plurality of back-side trench openings through the back-side surface of the semiconductor wafer substrate.. In addition, the disclosed methodology includes selectively forming a plurality of n-type conductive regions in the semiconductor wafer substrate at a bottom of a first back-side trench opening which are positioned for electrical contact with one or more n-well regions in the semiconductor wafer substrate. The disclosed methodology also includes selectively forming a plurality of p-type conductive regions in the semiconductor wafer substrate at a bottom of a second back-side trench opening which are positioned for electrical contact with one or more p-well regions in the semiconductor wafer substrate. In selected embodiments, the plurality of n-type conductive regions is formed by filling the first back-side trench opening with a first trench-filling layer; selectively etching a first plurality of back-side partial-substrate via (PSV) openings through the first trench-filling layer formed in the first back-side trench opening to expose the one or more n-well regions in the semiconductor wafer substrate; and selectively implanting a plurality of separate N+ implant regions at the bottom of the first plurality of back-side PSV openings to make ohmic contact with the one or more n-well regions in the semiconductor wafer substrate. In such embodiments, the plurality of p-type conductive regions are selectively formed by filling the second back-side trench opening with the first trench-filling layer; selectively etching a second plurality of back-side PSV openings through the second trench-filling layer formed in the second back-side trench opening to expose the one or more p-well regions in the semiconductor wafer substrate; and selectively implanting a plurality of separate P+ implant regions at the bottom of the second plurality of back-side PSV openings to make ohmic contact with the one or more p-well regions in the semiconductor wafer substrate. In selected embodiments, a femtosecond laser may be scanned to apply a localized anneal process to anneal the plurality of separate N+ implant regions and the plurality of separate P+ implant regions. In selected embodiments, the plurality of n-type conductive regions are selectively formed by filling the first back-side trench opening with a first trench-filling layer; selectively etching a plurality of PSV openings through the first trench-filling layer formed in the first back-side trench opening to expose the one or more n-well regions in the semiconductor wafer substrate; and providing an n-type solid phase diffusion source to form a plurality of separate N+ regions at the bottom of the plurality of back-side PSV openings to make ohmic contact with the one or more n-well regions in the semiconductor wafer substrate. In other selected embodiments, the plurality of p-type conductive regions are formed by filling the second back-side trench opening with a first trench-filling layer; selectively etching a plurality of back-side PSV openings through the first trench-filling layer formed in the second back-side trench opening to expose the one or more p-well regions in the semiconductor wafer substrate; and providing a p-type solid phase diffusion source to form a plurality of separate P+ regions at the bottom of the plurality of back-side PSV openings to make ohmic contact with the one or more p-well regions in the semiconductor wafer substrate. In addition, the disclosed methodology includes forming, in the first back-side trench opening, a first back-side conductor which is directly electrically connected over plurality of n-type conductive regions to the one or more n-well regions in the semiconductor wafer substrate. The disclosed methodology also includes forming, in the second back-side trench opening, a second back-side conductor which is directly electrically connected over the plurality of p-type conductive regions to the one or more p-well regions in the semiconductor wafer substrate. In selected embodiments of the disclosed methodology, a plurality of integrated-circuit (IC) devices is formed on the front-side surface of the semiconductor wafer substrate layer. In selected embodiments, the disclosed method may also include selectively forming one or more dielectric sidewall layers in the first back-side trench opening which leaves exposed the n-type conductive region. In selected embodiments, the disclosed methodology also includes forming a decoupling metal-insulator-metal (MIM) capacitor plate layer on the back-side surface of the semiconductor wafer substrate as part of forming the first back-side conductor. In selected embodiments, the formation of the first and second back-side conductors may include sequentially depositing one or more conductive layers to fill the first and second back-side trench openings, to make ohmic contact with the plurality of n-type conductive regions and the plurality of p-type conductive regions, and to cover the back-side surface of the semiconductor wafer substrate; and selectively etching the one or more conductive layers on the back-side surface of the semiconductor wafer substrate to form the first and second back-side conductors.

In yet another form, there is provided an integrated-circuit and associated method of fabrication. As disclosed, the integrated-circuit includes a semiconductor substrate having first and second well regions located below a front-side surface of the semiconductor substrate with a plurality of integrated-circuit (IC) devices formed on the front-side surface of the semiconductor substrate. In addition, the integrated-circuit includes one or more first defined conductive regions located in the semiconductor substrate and in electrical contact with the first well region. The integrated-circuit also includes one or more second defined conductive regions located in the semiconductor substrate and in electrical contact with the second well regions. In addition, the integrated-circuit includes a first conductive partial-semiconductor rail structure formed through a back-side surface of the semiconductor substrate to extend only partway through the semiconductor substrate to directly, electrically connect to the first well region through the one or more first defined conductive regions, where the first conductive partial-semiconductor rail structure has a first length extending across a substantial portion of the back-side surface of the semiconductor substrate. The integrated-circuit also includes a second conductive partial-semiconductor rail structure formed through a back-side surface of the semiconductor substrate to extend only partway through the semiconductor substrate to directly, electrically connect to the second well region through the one or more second defined conductive regions, where the second conductive partial-semiconductor rail structure has a second length extending across a substantial portion of the back-side surface of the semiconductor substrate. In selected embodiments, the integrated-circuit also includes an integrated back-side decoupling-capacitor plate which is directly electrically connected with the first conductive partial-semiconductor rail structure or second conductive partial-semiconductor rail structure.

Although the described exemplary embodiments disclosed herein are directed to various semiconductor and integrated-circuit device structures and methods for making the same, the present invention is not necessarily limited to the example embodiments which illustrate inventive aspects of the present invention that are applicable to a wide variety of semiconductor processes and/or devices. Thus, the particular embodiments disclosed above are illustrative only and should not be taken as limitations upon the present invention, as the invention may be modified and practiced in different but equivalent manners apparent to those skilled in the art having the benefit of the teachings herein. Accordingly, the foregoing description is not intended to limit the invention to the particular form set forth, but on the contrary, is intended to cover such alternatives, modifications and equivalents as may be included within the scope of the invention as defined by the appended claims so that those skilled in the art should understand that they can make various changes, substitutions and alterations without departing from the scope of the invention in its broadest form.

Benefits, other advantages, and solutions to problems have been described above with regard to specific embodiments. However, the benefits, advantages, solutions to problems, and any element(s) that may cause any benefit, advantage, or solution to occur or become more pronounced are not to be construed as a critical, required, or essential feature or element of any or all the claims. As used herein, the terms "comprises," "comprising," or any other variation thereof, are intended to cover a non-exclusive inclusion, such that a process, method, article, or apparatus that comprises a list of elements does not include only those elements but may include other elements not expressly listed or inherent to such process, method, article, or apparatus.

## Claims

1. A method for forming power-distribution conductors on a back-side of a semiconductor substrate, comprising:
selectively forming a first opening on the back-side surface of the semiconductor substrate to extend only partway through the semiconductor substrate;
selectively forming a plurality of defined first conductive regions of a first conductivity type at a bottom portion of the first opening to be positioned for electrical contact with one or more first well regions in the semiconductor substrate; and
selectively forming a first back-side power-distribution conductor in the first opening which is directly electrically connected over the plurality of defined first conductive regions to the one or more first well regions in the semiconductor substrate.

2. The method of claim 1, further comprising:
selectively forming a second opening on the back-side surface of the semiconductor substrate to extend only partway through the semiconductor substrate;
selectively forming a plurality of defined second conductive regions of a second, opposite conductivity type at a bottom portion of the second opening to be positioned for electrical contact with one or more second well regions in the semiconductor substrate;
selectively forming a second back-side power-distribution conductor in the second opening which is directly electrically connected over the plurality of defined second conductive regions to the one or more second well regions in the semiconductor substrate; and
selectively forming one or more patterned conductive layers on the back-side surface of the semiconductor substrate to form an integrated back-side decoupling-capacitor plate which is directly electrically connected with the first or second back-side power-distribution conductor, where the integrated back-side decoupling-capacitor plate is a first metal-insulator-metal (MIM) capacitor plate and the semiconductor substrate is a second MIM capacitor plate.

3. The method of claim 2, further comprising selectively forming, before selectively forming the first back-side power-distribution conductor, one or more dielectric sidewall layers on sidewall surfaces of at least one of the first or second openings which leave exposed the plurality of defined first conductive regions and the plurality of defined second conductive regions.

4. The method of claim 2 or claim 3, where selectively forming the plurality of defined first conductive regions comprises selectively implanting a plurality of separate N+ implant regions into the semiconductor substrate at the bottom of the first opening, and where selectively forming the plurality of defined second conductive regions comprises selectively implanting a plurality of separate P+ implant regions into the semiconductor substrate at the bottom of the second opening.

5. The method of claim 4, further comprising scanning a femtosecond laser to apply a localized anneal process to anneal the plurality of separate N+ implant regions and the plurality of separate P+ implant regions.

6. The method of any of claims 2 to 5, where selectively forming the plurality of defined first conductive regions comprises selectively forming a plurality of separate N+ diffusion regions in the semiconductor substrate at the bottom of the first opening, and where selectively forming the plurality of defined second conductive regions comprises selectively forming a plurality of separate P+ diffusion regions in the semiconductor substrate at the bottom of the second opening.

7. The method according to any preceding claim, where selectively forming the plurality of defined first conductive regions comprises:
filling the first opening with a first trench-filling layer;
selectively etching a first plurality of back-side partial-substrate via (PSV) openings through the first trench-filling layer formed in the first opening to expose one or more n-well regions in the semiconductor substrate; and
selectively implanting a plurality of separate N+ implant regions at the bottom of the first plurality of back-side PSV openings to make ohmic contact with the one or more n-well regions in the semiconductor wafer substrate.

8. The method of claim 2, where selectively forming the plurality of defined second conductive regions comprises:
filling the second opening with a first trench-filling layer;
selectively etching a second plurality of back-side PSV openings through the first trench-filling layer formed in the second opening to expose one or more p-well regions in the semiconductor substrate; and
selectively implanting a plurality of separate N+ implant regions at the bottom of the second plurality of back-side PSV openings to make ohmic contact with the one or more p-well regions in the semiconductor substrate.

9. The method of any preceding claim, where selectively forming the first back-side power-distribution conductor comprises:
sequentially depositing one or more conductive layers to fill the first opening and to cover the back-side surface of the semiconductor substrate; and
selectively etching the one or more conductive layers on the back-side surface of the semiconductor substrate to form the first back-side power-distribution conductor.

10. An integrated-circuit, comprising:
a semiconductor substrate comprising first and second well regions located below a front-side surface of the semiconductor substrate with a plurality of integrated-circuit (IC) devices formed on the front-side surface of the semiconductor substrate;
one or more first defined conductive regions located in the semiconductor substrate and in electrical contact with the first well region;
one or more second defined conductive regions located in the semiconductor substrate and in electrical contact with the second well regions;
a first conductive partial-semiconductor rail structure formed through a back-side surface of the semiconductor substrate to extend only partway through the semiconductor substrate to directly, electrically connect to the first well region through the one or more first defined conductive regions, where the first conductive partial-semiconductor rail structure has a first length extending across a substantial portion of the back-side surface of the semiconductor substrate; and
a second conductive partial-semiconductor rail structure formed through a back-side surface of the semiconductor substrate to extend only partway through the semiconductor substrate to directly, electrically connect to the second well region through the one or more second defined conductive regions, where the second conductive partial-semiconductor rail structure has a second length extending across a substantial portion of the back-side surface of the semiconductor substrate.

11. The integrated-circuit of claim 10, further comprising an integrated back-side decoupling-capacitor plate that is directly electrically connected with the first conductive partial-semiconductor rail structure or second conductive partial-semiconductor rail structure.
